# EUROPEAN PATENT APPLICATION

(11) **EP 2 860 229 A1**
(43) Date of publication of application: **15.04.2015**
(21) Application number: 14188465.0
(22) Date of filing: 10.10.2014
(51) Int. Cl.: C09D 127/12, H01B 3/44, H01L 23/29

(54) **ELECTRICAL LEAD FRAME WITH PROTECTIVE COATING AND METHOD OF APPLYING SAME**

(30) Priority: 14.10.2013 US 201314053212
(71) Applicant: General Electric Company, Schenectady, New York 12345 (US)
(72) Inventor: Seaton, John David, Schenectady, NY 12345 (US)
(74) Representative: P&TS SA (AG, Ltd.)

(57) **Abstract**

Electrical component assemblies and other electrical connectors are provided having protective coatings that allow for use in high temperature and highly corrosive environments. Methods for applying protective coatings are also provided. In one embodiment, a connector is provided and includes a protective coating that encapsulates at least a portion thereof. The connector can be, for example, an electrical lead frame, or a connector having a distal side and a proximal side that is disposed in an automotive fuel system such that the distal side is sealed from the proximal side. Methods for coating connectors are also provided.

## Description

### FIELD

The subject matter disclosed herein relates to electrical components such as electrical lead frames and connectors with protective coatings for use in high temperature and highly corrosive environments, including automotive fuel systems.

### BACKGROUND

As environmental regulations become increasingly stringent, new technology is being utilized to permit compliance by combustion engines. For example, within the automotive industry, Selective Catalyst Reduction (SCR) systems and Exhaustive Gas Recirculation (EGR) systems have been developed to limit nitrous oxide (NOx) and particulate emissions.

SCR systems, for example, typically operate by injecting a precisely metered volume of a reductant, such as a urea solution, into the hot exhaust downstream of the engine, where the urea solution breaks down into ammonia and reacts with the exhaust gasses in the presence of a catalytic converter to convert NOx into nitrogen and water. The urea solution can contain about 32.5% urea in demineralized water known as Diesel Exhaust Fluid. This urea solution typically freezes at about -11°C, which thus requires the temperature of the fluid to be monitored and controlled by various electrical components disposed within a tank containing the urea solution. However, the urea solution can be corrosive to traditional electrical components, such as sensors, including thermistors, and heating assemblies.

EGR systems can recycle at least a portion of the exhaust gases back into the engine's combustion chamber. While EGR systems reduce emission of certain pollutants, including NOx, when the exhaust gases are recycled within the engine, engine components are exposed to high concentrations of these gases for long periods of time. This results in elevated acid levels within the EGR system, including nitric and sulfuric acid. The high temperature and highly corrosive environment can negatively affect the functioning of the engine components and sensors, including thermistors, heaters, electrical lead frames, and various other system components that are disposed in the EGR system.

Additionally, automotive fuel systems often contain various aromatic hydrocarbons and other corrosive gasses. These hydrocarbons and gasses can degrade electrical connectors disposed in the fuel system and can be harmful if leaked from within the fuel system to the ambient environment. To prevent leakage from the fuel system, electrical connectors are typically sealed with a gasket such as a silicone overmold. However, over time, the gaskets can degrade as they are exposed to the corrosive fuel system environment thus allowing the corrosive gasses to leak to the dry side of the fuel system or to the ambient environment.

Accordingly, there remains a need for improved electrical components with protective coatings and seals for use in high temperature and highly corrosive environments.

### BRIEF DESCRIPTION

Electrical component assemblies and other electrical connectors are provided having protective coatings that allow for use in high temperature and highly corrosive environments. Methods for applying protective coatings are also provided.

In one embodiment, an electrical component assembly is provided and includes an electrical component lead frame and a protective coating that encapsulates at least a portion of the electrical component lead frame. The electrical component assembly can be used in various applications, such as in an automotive fuel system. Advantageously, the protective coating can form a gasket or protect the electrical component assembly or connector without being electrically conductive. In one exemplary embodiment, the protective coating can be a fluoroelastomeric polymer that is free of carbon black.

In another embodiment, an automotive fuel system is provided and includes an engine with at least one cylinder or chamber and a fuel tank fluidly coupled to the engine and configured to contain an aromatic hydrocarbon fuel. The automotive fuel system also includes an electrical connector having a proximal side and a distal side. The distal side can be disposed within the fuel tank. A protective coating, such as a fluoroelastomeric polymer that is free of carbon black, can encapsulate at least a portion of the electrical connector such that the proximal side is isolated from the distal side. While the configuration of the electrical connector and coating can vary, the electrical connector can, for example, be an electrical lead frame and the protective coating can, for example, form a gasket on a central portion of the electrical connector.

Methods for coating an electrical lead frame are also provided, and in one embodiment the method can include suspending a fluoroelastomeric polymer in an organic carrier solvent, adjusting a viscosity of the organic carrier solvent, cooling the suspended fluoroelastomeric polymer to a temperature below ambient temperature, depositing the fluoroelastomeric polymer onto at least a portion of an electrical lead frame, permitting at least some of the organic carrier solvent to evaporate, thereby producing a conformal layer of fluoroelastomeric polymer on the electrical lead fame, and curing the conformal layer to produce an at least partially coated electrical lead frame.

### BRIEF DESCRIPTION OF THE DRAWING

These and other features will be more readily understood from the following detailed description taken in conjunction with the accompanying drawings, in which:
FIG. 1 is a side view of one embodiment of an electrical component assembly with a protective coating;
FIG. 2 is a flow diagram of one embodiment of a method of coating an electrical lead frame;
FIG. 3 is a side view of the electrical component lead frame of FIG. 1 with a mold disposed thereon; and
FIG. 4 is a schematic diagram of one embodiment of an automotive fuel system.

It is noted that the drawings are not necessarily to scale. The drawings are intended to depict only typical aspects of the subject matter disclosed herein, and therefore should not be considered as limiting the scope of the disclosure. In the drawings, like numbering represents like elements between the drawings.

### DETAILED DESCRIPTION

Certain exemplary embodiments will now be described to provide an overall understanding of the principles of the structure, function, manufacture, and use of the devices, systems, and methods disclosed herein.

Electrical components, such as lead frames and various other connectors such as wires and ribbons, are often disposed in harsh environments that require protection from the immediate environment. For example, electrical component lead frames and other connectors are frequently disposed in fuel systems containing various aromatic hydrocarbon compounds, other corrosive gasses, and high temperatures. Accordingly electrical component lead frames and other connectors are provided having protective coatings that provide protection from high temperatures and/or highly corrosive environments.

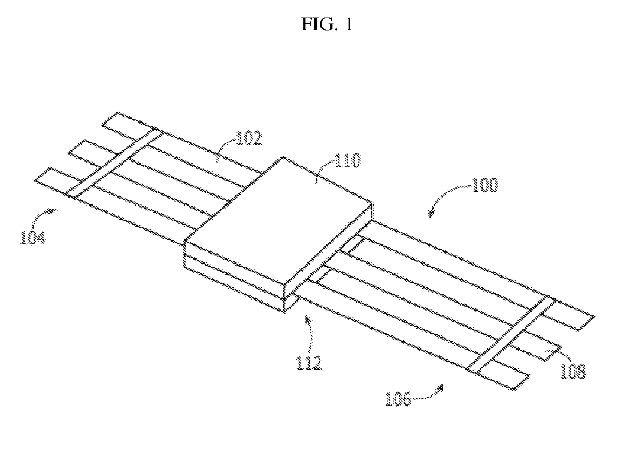

FIG. 1 illustrates one embodiment of an electrical component assembly 100, for use as, for example, an electrical connector in an automotive fuel system. The electrical component assembly 100 generally includes an electrical lead frame 102 having a proximal side 104 and a distal side 106, with a plurality of leads 108 extending between the proximal and distal sides 104, 106. Both the proximal and distal sides 104, 106 can be configured to mate with a system component, such as an electronic assembly, pump, sensor, or control unit (not shown), providing an electrical connection between system components. Additionally, the electrical component assembly 100 includes a protective coating 110 that can encapsulate at least a portion of the electrical component assembly 100, including all or at least a portion of the electrical component lead frame 102. In some embodiments, the electrical component assembly 100 can further include a polymer casing layer (not shown) disposed over at least a portion of the electrical component lead frame and either under or on top of the protective coating.

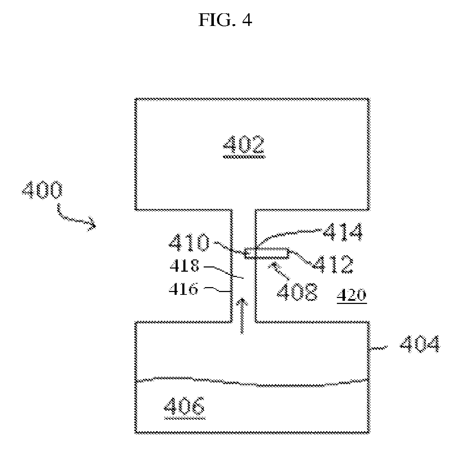

The electrical lead frame 102 can have a variety of configurations and it can be any lead frame known in the art. For example, as shown in FIG. 4, the electrical lead frame can be configured for use in an automotive fuel system to provide an electrical connection from a dry side of the fuel system to a wet side of the fuel system. The electrical lead frame 102 can be formed of any conductive material known in the art, for example, metals such as stainless steel, brass, copper, conductive polymers, ceramics, and any other conductive material. The electrical lead frame 102 can be formed using any method known in the art, such as stamping from sheet metal and die cutting. The electrical lead frame can have any dimension suitable for the intended application.

As mentioned, the electrical component assembly 100 can optionally include a polymer casing layer (not shown). The polymer casing layer can be configured to encapsulate at least a portion of the electrical lead frame 102. In some embodiments, the polymer casing layer can be formed on and in direct contact with a central portion 112 of the electrical lead frame 102. In other embodiments, the polymer casing layer can be disposed on top of the protective coating. The polymer casing layer can be formed of any known casing material such as polymers and ceramics including phenolic resin, nylons (such as nylon-6,6), epoxy, PVC, polyimide, silicone, polyethylenes (such as high density polyethylene), ceramic cement, lacquer, urethane, shrink sleeving, glass encapsulation, and any combination thereof. For example, the polymer casing can include at least one of an aliphatic polyamide and a high density polyethylene. The polymer casing layer can be formed and deposited by any known method, including the methods for depositing the protective coating described herein.

As shown in FIG. 1, the protective coating 110 encapsulates at least a portion of the electrical component assembly 100. In some embodiments, the protective coating 110 can encapsulate a portion of the lead frame 102. In some embodiments, the end portions of the lead frame can be left uncoated so as to allow proper electrical connection with any desired system components. In certain exemplary embodiments, the protective coating 110 encapsulates only a central portion 112 of the lead frame 102. Such a configuration can allow the protective coating 110 to form a seal or gasket on the lead frame 102, as will be discussed below. The protective coating 110 can be disposed on top of the polymer casing layer, or alternatively can be formed directly on the electrical lead frame 102. As will be discussed below, the protective coating 110, either alone or in combination with the polymer casing, can form a nonconductive sealing gasket and can be formed in a variety of manners, for example by forming a mold over a portion of the electrical lead frame 102 and depositing the coating onto at least a portion of the electrical lead frame 102. Additional methods of depositing the protective coating 110 are appreciated, including but not limited to, injection molding methods, spray casting, chemical vapor deposition, and any other method of depositing a polymer layer known in the art.

In one exemplary embodiment, the protective coating 110 is made of a fluoroelastomeric polymer. Fluoroelastomeric polymers (FKM) are a class of polymers that exhibit resistance to corrosion. Fluoroelastomeric polymers are typically used to form o-rings, gaskets, and seals for automotive, aerospace and/or industrial applications of machines by injection molding. Since many of these fluoroelastomeric polymers include electrically conductive additives to facilitate the molding process, conventional fluoroelastomeric polymers are undesirable for use with electrical devices, including heating assemblies.

The fluoroelastomeric polymer used for the protective coating 110 is selected to provide an acceptable level of chemical durability to resist the corrosive environment of automotive fuel systems, including resistance to volatile organic fuels, urea, nitric acid, sulfuric acid and biodiesel combustion products at elevated temperatures without including electrically conductive additives. The fluoroelastomeric polymer is designed to function as an electrically insulating coating with dielectric strengths of about 50kV per millimeter or greater. In some embodiments, the resistance value is greater than 100 Mega ohms at 500 volts. The fluoroelastomeric polymer should also have sufficient hardness to safeguard the electrical component assembly 100 against physical damage, for example, a Shore A hardness of 60 or greater. Sufficient flexibility to permit the electrical component assembly 100 to bend can also be desirable. The fluoroelastomeric polymer is also selected to exhibit acceptable water immersion resistance (e.g., minimal change of resistance of the electrical component assembly 100 after 1000 hours of water immersion at 85°C under 5V of power with a 6.81 kilo ohm series resistor) and mechanical properties (e.g., able to endure over 3000 cycles of thermal shock between -40°C and 155°C). The fluoroelastomeric polymer should also be capable of surviving curing temperature of about 200°C without negatively impacting performance. One or more of these properties are present in the harsh environment of the automotive fuel system, EGR system, and/or SCR system, which can include high concentrations of acids at high temperatures. To permit proper coating of the electrical component assembly 100, the fluoroelastomeric polymer is capable of being applied by deposition and/or dip coating.

The fluoroelastomeric polymer can be formed from the polymerization product of a reaction mixture that includes a fluorinated or perfluorinated monomer with one or more co-monomers. Examples of suitable monomers include vinylidene fluoride and tetrafluoroethylene. Examples of suitable co-monomers include fluorinated propylenes, such as hexafluoropropylene. Further examples of suitable monomers include tetrafluoroethylene and perfluoromethylvinylether. The resulting fluoroelastomeric polymer is typically 60% fluorine or more by weight and is saturated. One suitable fluoroelastomeric polymer is sold by Du Pont under the trade name VITON®. Care must be taken to select a fluoroelastomeric polymer formulation where conductive processing aids, such as carbon black, are omitted (e.g. Non-Black VITON®).

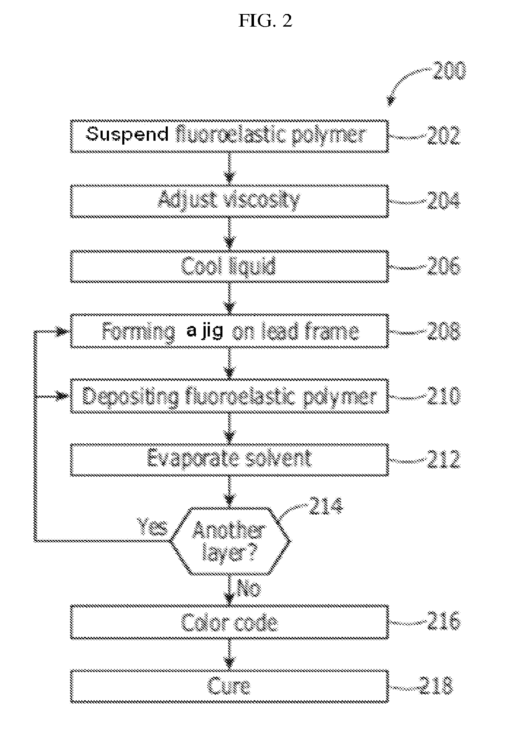

FIG. 2 is a flow diagram depicting an exemplary method 200 for coating an electrical component assembly 100 with a protective coating. It should be noted that although the method 200 is described particularly with respect to the electrical lead frame 102 of FIG. 1, it can be applied to any desired electrical component assembly. In step 202, a fluoroelastic polymer is suspended in an organic carrier solvent. In one embodiment, an organic carrier solvent with high volatility is selected to permit rapid evaporation after coating. Examples of suitable organic carrier solvents include low molecular weight ketones, such as methylethylketone, acetone, etc. Other suitable organic carrier solvents would be apparent to those skilled in the art after benefitting from reading this specification. A sufficient quantity of the organic carrier solvent is used to provide a, for example, 30% to 50% liquid by weight, based on the desired viscosity. In one embodiment, the fluoroelastic polymer formulation includes solids. Generally, the solids are selected to be chemically inert. Examples of suitable solids include metal oxides such as titanium dioxide and silicon dioxide.

In step 204, the viscosity of the suspended fluoroelastic polymer is adjusted. In one embodiment, the viscosity is adjusted by adding a sufficient amount of the organic carrier solvent to achieve a desired viscosity. The viscosity is adjusted to, for example, a value of between 1000 centipoise and 5000 centipoise. In some embodiments, the viscosity is adjusted by permitting a portion of the organic carrier solvent to evaporate.

In step 206, the liquid is cooled to a temperature below ambient temperature to reduce the rate of evaporation of the organic carrier solvent. The liquid may be cooled to a temperature that is about 10°C cooler than the ambient temperature. In one exemplary embodiment, the ambient temperature is about 25°C and the liquid may be cooled to a temperature of about 15°C.

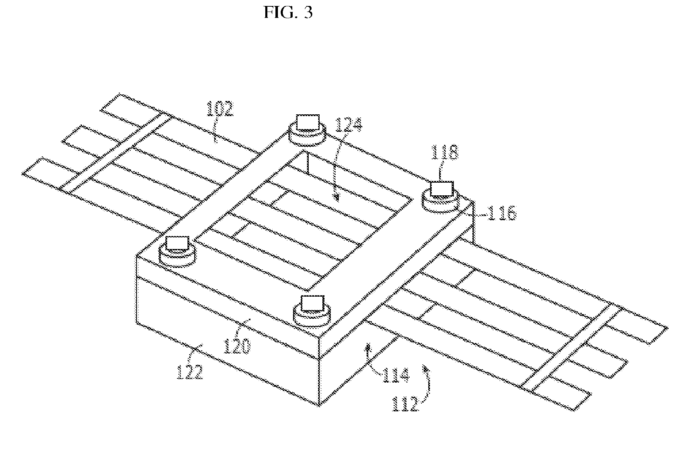

In step 208, a jig can optionally be formed on a portion of the electrical lead frame 102. As is shown in FIG. 3, the jig 114 can be formed over a central portion 112 of the electrical lead frame 102 and can be configured to provide a form or frame for depositing the polymer such that the jig 114 will contain the liquid polymer in a desired location on the lead frame 102 as it is deposited thereon. The jig 114 can be configured to clamp on to the lead frame 102 using a variety of configurations, for example by using nuts 116 and bolts 118 to sandwich the lead frame 102 between a top jig plate 120 and a bottom jig plate 122. In such a configuration, the top jig plate 120 can have a form opening 124 for pouring the polymer into and the bottom jig plate 122 can be a solid plate to maintain the liquid polymer. In this manner, to form a sandwiched configuration as is discussed in step 208, the jig 114 must be unclamped and the lead frame 102 flipped over following the coating of a first side of the lead frame to allow the coating of the opposing second side of the lead frame. The jig 114 can be formed of any known material, such as various metals or polytetrafluoroethylene, available from DuPont under the tradename TEFLON®.

In step 210, the cooled fluoroelastomeric polymer is deposited onto at least a portion of the electrical lead frame 102. In some embodiments, step 210 can include pouring the cooled fluoroelastomeric polymer onto the electrical lead frame 102, for example into the jig 114 discussed in step 208. The amount of fluoroelastomeric polymer deposited controls the thickness of the resulting layer. When a thick layer is desired, more fluoroelastomeric polymer can be deposited into the jig 114, relative to when a thin layer is desired. In some embodiments, multiple layers are deposited, one atop another, and provide a conformal layer of a predetermined thickness. Also, in some embodiments, step 210 can include first forming a polymer casing layer directly on the lead frame or on top of a previously deposited polymer coating layer.

In step 212, at least a portion of the organic carrier solvent is permitted to evaporate to form a semisolid conformal layer of the newly deposited fluoroelastomeric polymer. In one embodiment, step 212 further comprises an ambient drying step that lasts for at least two minutes. For example, the newly deposited fluoroelastomeric polymer may be exposed to the ambient environment for about two minutes to permit the organic carrier solvent to evaporate. Since the ambient environment is warm relative to the temperature of the organic carrier solvent, evaporation is facilitated.

In step 214, a determination is made concerning whether or not an additional layer of fluoroelastomeric polymer should be deposited. For example, another layer can be deposited on top of the previously deposited layer, or alternatively, a layer can be formed on the opposite side of the electrical lead frame 102. That is, a sealing gasket can be formed by effectively sandwiching a portion of the electrical lead frame 102 in between two layers of the fluoroelastomeric polymer that form a seal between the layers sandwiching the lead frame. If another layer is desired, the method 200 returns to step 208 and/or 210 and the fluoroelastomeric polymer is deposited again. This deposits an additional layer of fluoroelastomeric polymer atop the previously deposited layer(s) or deposits a layer of fluoroelastomeric polymer on the opposing side of the electrical lead frame 102, as necessary. If another layer is not desired, step 216 may be executed wherein a portion of the coated lead frame is dipped in a colorant and/or has a colorant deposited thereon to provide a coating of a predetermined color for color coding. A variety of compatible colorants are known in the art. In one embodiment, two layers of fluoroelastomeric polymer are provided. In another embodiment, three layers of fluoroelastomeric polymer are provided.

In step 218, the layer(s) of fluoroelastomeric polymer are cured to encapsulate the electrical lead frame 102. In one embodiment, the curing step includes heating the coated electrical lead frame 102 to a predetermined temperature for a predetermined time that is selected to remove the organic carrier solvent and cross-link (vulcanize) the fluoroelastic polymer. For example, the coated electrical lead frame 102 may be heated to a temperature of about 100°C for about thirty minutes. The coated electrical lead frame 102 may also be subjected to a stepwise heating process that both drives off any residual organic carrier solvent as well as cures the layers of fluoroelastomeric polymer to seal the electrical lead frame within the fluoroelastomeric polymer. An exemplary stepwise heating process heats the cured, coated electrical lead frame 102 to a temperature of about 90°C for a predetermined period of time. Thereafter, the temperature is increased to about 160°C for a predetermined period of time. Two additional stepwise heating processes are likewise performed at temperatures of 180°C and 200°C.

Components, such as electrical lead frames and various other connectors, coated using the described methods are ideal for use in corrosive environments. Electrical lead frames coated in accordance with the teachings herein prevent corrosives, such as fuel vapors, moisture and ammonia, from penetrating to the surface of the lead frame or from leaking through a seal or gasket formed by the coating. In this respect, the coating is shown to prevent corrosion and to provide and maintain a sealing interface. The coating has shown to provide excellent vapor tightness and little variation over time in helium tightness tests.

In use, an electrical connector can be used in an automotive fuel system 400, as shown in FIG. 4. The automotive fuel system includes an engine 402 with at least one cylinder chamber and a fuel tank 404 fluidly coupled to the engine 402 and configured to contain an aromatic hydrocarbon fuel 406. The automotive fuel system 400 also includes an electrical connector 408, such as the electrical component assembly 100 shown in FIG. 1 or any other lead frame or connector. The electrical connector 408 can have a protective coating encapsulating at least a portion of the connector 408 as described herein. The protective coating can be a fluoroelastomeric polymer that is free of carbon black.

The engine 402 can be any combustion engine, for example, an automotive combustion engine having at least one cylinder chamber. Additionally, the engine can include emission reduction systems, such as an SCR and/or EGR. The fuel tank 404 can be formed of any known material capable of holding the aromatic hydrocarbon fuel 406, such as gasoline, diesel, or ethanol. For example, the fuel tank 404 can be formed of a polymer or metal.

The electrical connector 408 can be configured to be disposed in the fuel system 400 such that a distal side 410 of the connector is exposed to the aromatic hydrocarbon fuel 406 as it flows through the automotive fuel system 400 and a proximal side 412 of the electrical connector 408 is disposed in an area that is not exposed to the aromatic hydrocarbon fuel 406. In such an embodiment, the electrical connector 408 can have a protective coating encapsulating at least a portion of the connector such that the proximal side 412 is isolated from the distal side 410 when the connector is disposed, for example, through a sidewall of a pipe 416 in the automotive fuel system 400. That is, the protective layer can form a gasket on a central portion 414 of the connector 408. The protective coating can be any of the coatings described herein, such as a fluoroelastomeric polymer that is free of carbon black, and can provide an impermeable barrier layer preventing moisture and corrosives, such as fuel vapors, from reaching the component or from leaking from the wet side 418 to the dry side 420 of the automotive fuel system 400. For example, the protective coating can include a fluoroelastic polymer that is a polymerization product of a reaction mixture that includes at least one co-monomer and tetrafluoroethylene and/or vinylidene fluoride. The co-monomer can include polypropylene, such as hexafluoropropylene. Additionally, the protective coating can further include a polymer casing layer, such as described herein, which can include at least one of an aliphatic polyamide and a high density polyethylene.

In a first embodiment of an automotive fuel system comprises: an engine with at least one cylinder chamber; a fuel tank fluidly coupled to the engine and configured to contain an aromatic hydrocarbon fuel; an electrical connector having a proximal side and a distal side, wherein the distal side is disposed within the fuel tank; and a protective coating encapsulating at least a portion of the electrical connector such that the proximal side is isolated from the distal side, wherein the protective coating comprises a fluoroelastomeric polymer that is free of carbon black.

In a second embodiment, the automotive fuel system is based on the first embodiment, wherein the fluoroelastomeric polymer comprises a polymerization product of a reaction mixture comprising at least one co-monomer and tetrafluoroethylene and/or vinylidene fluoride.

In a third embodiment, the automotive fuel system is based on the first or second embodiment, wherein the protective coating forms a gasket on a central portion of the electrical connector.

In a fourth embodiment, the automotive fuel system is based on the first, second or third embodiment, wherein the electrical connector is a lead frame.

In a fifth embodiment, the automotive fuel system is based on the first, the second, the third or the fourth embodiment, wherein the protective coating further comprises a polymer casing layer.

In a sixth embodiment, the automotive fuel system of claim 13, wherein the polymer casing layer is formed of at least one of an aliphatic polyamide and a high density polyethylene.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. An electrical component assembly, comprising:
an electrical lead frame; and
a protective coating encapsulating at least a portion of the electrical component lead frame, wherein the protective coating comprises a fluoroelastomeric polymer that is free of carbon black.

2. The electrical component assembly of claim 1, wherein the protective coating forms a gasket.

3. The electrical component assembly of claim 1 or 2, wherein the fluoroelastomeric polymer comprises a polymerization product of a reaction mixture comprising at least one co-monomer and tetrafluoroethylene and/or vinylidene fluoride.

4. The electrical component assembly of claim 3, wherein the at least one co-monomer includes a propylene.

5. The electrical component assembly of claim 4, wherein the propylene is hexafluoropropylene.

6. The electrical component assembly of anyone of claims 1 to 5, further comprising a polymer casing layer disposed over at least a portion of the electrical component lead frame.

7. The electrical component assembly of claim 6, wherein the protective coating is disposed on top of the polymer casing layer.

8. The electrical component assembly of claim 6 or 7, wherein the polymer casing layer is formed of at least one of an aliphatic polyamide and a high density polyethylene.

9. An automotive fuel system, comprising:
an engine with at least one cylinder chamber;
a fuel tank fluidly coupled to the engine and configured to contain an aromatic hydrocarbon fuel;
an electrical connector having a proximal side and a distal side, wherein the distal side is disposed within the fuel tank; and
a protective coating encapsulating at least a portion of the electrical connector such that the proximal side is isolated from the distal side, wherein the protective coating comprises a fluoroelastomeric polymer that is free of carbon black.

10. A method of coating an electrical lead frame, comprising:
suspending a fluoroelastomeric polymer in an organic carrier solvent;
adjusting a viscosity of the organic carrier solvent;
cooling the suspended fluoroelastomeric polymer to a temperature below ambient temperature;
depositing the suspended fluoroelastomeric polymer onto at least a portion of an electrical lead frame;
permitting at least some of the organic carrier solvent to evaporate, thereby producing a conformal layer of the fluoroelastomeric polymer on the electrical lead fame; and
curing the conformal layer to produce an at least partially coated electrical lead frame.

11. The method of claim 10, further comprising repeating the steps of depositing the suspended fluoroelastomeric polymer onto at least a portion of the electrical lead frame and permitting at least some of the organic carrier solvent to evaporate to form a plurality of conformal layers.

12. The method of claim 10 or 11, wherein permitting at least some of the organic carrier solvent to evaporate includes drying at ambient conditions for at least about 2 minutes.

13. The method of anyone of claims 10 to 12, wherein curing includes heating the electrical lead frame to a temperature of at least about 100°C for about 30 minutes.

14. The method of anyone of claims 10 to 13, wherein curing includes heating the electrical lead frame to a predetermined temperature for a predetermined time selected to remove the organic carrier solvent and cross-link the fluoroelastomeric polymer.

15. The method of anyone of claims 10 to 14, wherein the fluoroelastomeric polymer is deposited over a polymer casing layer on the electrical lead frame and formed of at least one of an aliphatic polyamide and a high density polyethylene.
